Europäisches Patentamt

European Patent Office

Office européen des brevets

(11) Publication number: **0 351 896**
**A2**

## (12) EUROPEAN PATENT APPLICATION

(21) Application number: **89200837.6**

(22) Date of filing: **03.04.89**

(51) Int. Cl.4: **H01L 27/118 , H01L 27/06**

(30) Priority: **22.06.88 US 209765**

(43) Date of publication of application:
**24.01.90 Bulletin 90/04**

(84) Designated Contracting States:
**DE FR GB IT**

(71) Applicant: **LSI LOGIC CORPORATION**
**1551 McCarthy Boulevard**
**Milpitas, CA 95035(US)**

(72) Inventor: **Wong, Anthony Y.**
**21438 Meteor Drive**
**Cupertino, Ca 95014(US)**
Inventor: **Wong, Daniel**
**7055 Bret Harte Dr.**
**San Jose, Ca 95120(US)**
Inventor: **Chan, Steven S.**
**624 Patriot Place**
**Fremont, Ca 94539(US)**

(74) Representative: **Noz, Franciscus Xaverius, Ir.**
**et al**
**Algemeen Octrooibureau P.O. Box 645**
**NL-5600 AP Eindhoven(NL)**

(54) **Bi-cmos logic array.**

(57) An integrated circuit logic array is fabricated using a BiCMOS process so that it includes an optimum number of bipolar drivers. This is accomplished by means of a chip architecture having three regions: the array core is all CMOS logic gates; surrounding the core is a BiCMOS region; at the periphery of the array are simple bipolar and CMOS devices for I/O purposes. The chip can be fabricated to use these regions to create circuit paths of varying complexity, depending on the application. In a second embodiment, the array consists of cells each containing one bipolar device and several contiguous CMOS gates.

FIG 3

FIG. 8

## FIELD OF THE INVENTION

This invention relates to an improvement in the configuration in BiCMOS integrated circuit logic arrays. These are integrated circuits that contain both bipolar transistors and CMOS gates in a logic array.

## BACKGROUND OF THE INVENTION

Integrated logic circuits typically contain either bipolar circuits, which are high speed but also dissipate large amounts of electric power, or CMOS (complementary metal oxide semiconductor) circuits that use less power and can be fabricated at higher densities than bipolar devices.

Fabrication technology also permits fabrication of integrated circuits containing both bipolar and CMOS transistors. Typically this "BiCMOS" technology is used to manufacture circuits in which the logic gates include CMOS transistors which are connected to bipolar transistors which act as drivers. Such bipolar driver transistors are also referred to as "buffers", and serve as drivers for the output of the CMOS logic gates.

The prior art typically provides a bipolar driver for each CMOS gate or set of gates in a logic array. But, contrary to the prior art, in the typical application most CMOS gates do not need a bipolar driver transistor.

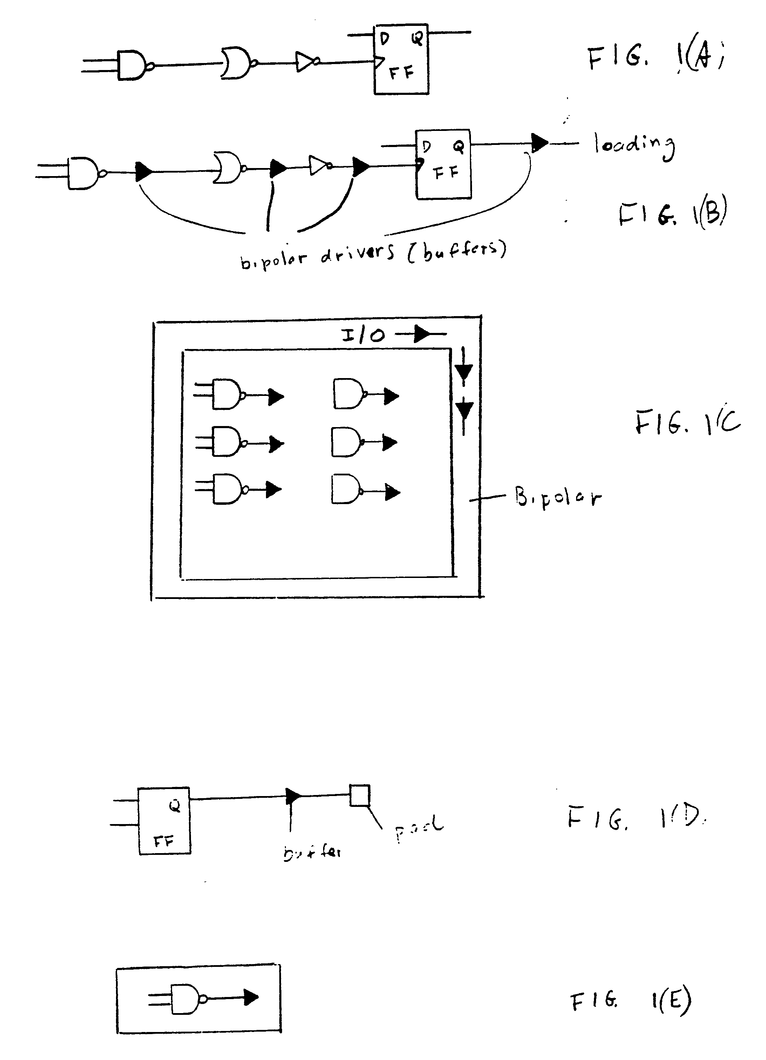

For example, for the logic circuit shown in Fig. 1(a), the prior art BiCMOS implementation is as shown in Fig. 1(b). In this prior art approach, a bipolar device is provided wherever a gate is used, creating two problems: (1) the bipolar devices take up valuable chip area; (2) for low fan out gates, the delay within the bipolar devices may increase overall circuit propagation delay.

The prior art in terms of chip architecture for BiCMOS logic arrays is as shown in Fig. 1(c) whereby each CMOS gate has an associated bipolar driver, with I/O (input/output) buffers dispersed around the periphery of the chip. Note that the prior art provides that whenever the output of a logic device is desired to go outside the chip, bipolar transistors are used as drivers between the logic device and the chip output bonding pad, as shown in Fig. 1(d) where a CMOS flip flop drives a bonding pad via a bipolar buffer.

Just as described above where gate-to-gate connections required extra buffers, this buffer adds to chip area and increases propagation delay.

## SUMMARY OF THE INVENTION

This invention provides a BiCMOS logic array configuration that optimizes the number of bipolar drivers needed on the chip.

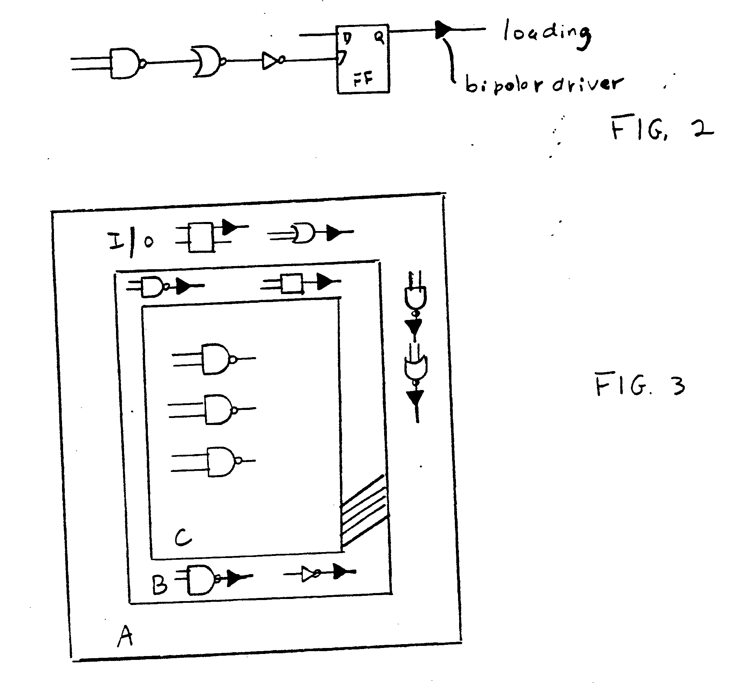

The most efficient way to implement the circuit of Fig. 1(a) using the present invention is as shown in Fig. 2, where the only bipolar driver is at the output end of the circuit so as to drive the loading. In Fig. 2, the bipolar driver is used only where it is needed, and not elsewhere, resulting in gate chip area savings and faster speed.

The output circuit as shown in Fig. 1(d) can also be implemented more efficiently by providing for the flip-flop output to go directly to the outside of the chip without adding an extra buffer involving bipolar devices. This is accomplished by substituting for the prior art output buffer a combination of CMOS and bipolar devices that are configurable to allow the required output functions to be performed. This combination of devices is more complicated than a standard buffer, but it allows for more flexible logic functions with bipolar drive capable of going directly outside the chip, which is called Direct DriveTM. This allows, for example, substituting a flip-flop circuit for a buffer transistor.

## DESCRIPTION OF DRAWINGS

FIG. 1(a) to (e) show prior art gate and chip architecture.

FIG. 2 shows the present invention at the gate level.

FIG. 3 shows an embodiment at the chip architecture level of the present invention.

FIG. 4-7 show various ways to use the present invention.

FIG. 8-10 show a second embodiment of the invention.

## DETAILED DESCRIPTION

The following detailed description of this invention is meant to be illustrative only and not limiting. Other embodiments of this invention will be obvious to those skilled in the art in view of the following disclosure.

The present invention, as described above, has the chip architecture shown in Fig. 3. The typical chip would have, using current fabrication technology, 5,000 to 50,000 gates, and support up to 345 input/output signals. Note the differences between the chip architecture of the present invention as described hereinafter and the prior art chip architecture as shown in Fig. 1(c).

In Fig. 3, the chip periphery, region A, includes I/O (Input/Output) devices consisting of relatively simple bipolar and CMOS logic devices. Those that are bipolar devices are capable of heavy current driving. Each output buffer has a sink and source rating of up to 24 mA; three such buffers in parallel can provide 72 mA per signal. Logic functions can thus be implemented in an I/O location because each I/O location includes several gates of logic. This allows logic functions such as basic gates, multiplexers, latches, flip-flops, or boundary scan flip-flops to be implemented at each I/O location thus reducing the delays for these logic functions.

To insure that peak switching currents will not adversely affect the operation of the internal logic, separate power and ground rails are provided for each of the outputs and inputs and internal gates. This scheme provides the necessary isolation from ground noise at the outputs that may otherwise contribute to internal logic noise.

An additional feature that can be provided is selectable series and parallel termination resistors within each I/O buffer area.

Region B is contiguous to Region A and contains BiCMOS devices of smaller geometry than those in Region A. Region B represents typically 3% to 5% of the total gates in any one array chip. The Region B gates are organized into blocks. Each block typically contains two 2-input CMOS gates and one 4-input BiCMOS gate. The blocks serve to optimize speed critical paths internal to the gate array logic design. Due ·to the smaller device size, more complex functions can be accommodated relative to chip area in Region B than in Region A.

The core and major portion of the chip is region C, which is a channelless CMOS gate array to provide the logic gate density needed for systems applications.

The BiCMOS array can be utilized to make circuit paths, as follows:

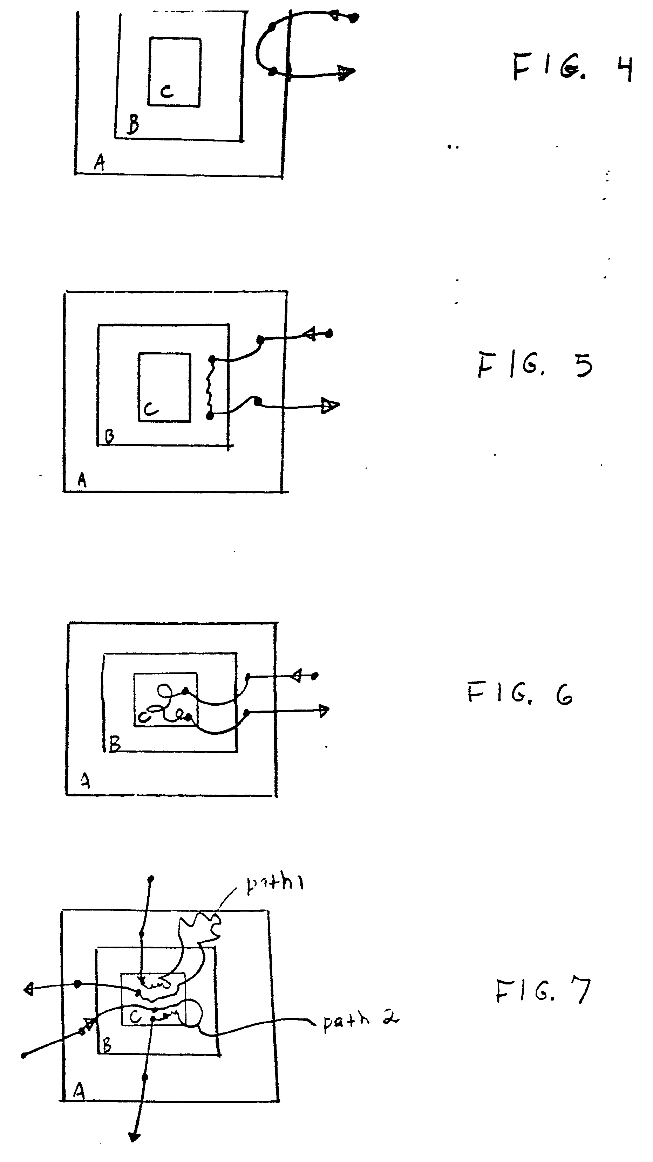

1. A simple circuit path as illustrated in Fig. 4 using BiCMOS devices exclusively in region A.

2. A more complicated path is illustrated in Fig. 5 using only BiCMOS devices in region A and B, to benefit from the more complex logic available in region B.

3. For systems use as illustrated in Fig. 6, using region A for I/O (driving and receiving) only, and using region C for its complex logic. In this usage, region B may or may not be used.

4. Some CMOS logic applications may require an occasional bipolar driver. In this case, path 1 or path 2 as illustrated in Fig. 7 can be used. Paths 1 and 2 provide bipolar drivers where necessary to augment CMOS driver capability.

Another embodiment of the invention uses a cell approach to reduce the number of drivers provided on a chip. As described above, the prior art provides one CMOS logic gate driving one bipolar buffer; this combination is a conventional cell. A prior art logic array chip consists of many such cells as shown in Fig. 1(e).

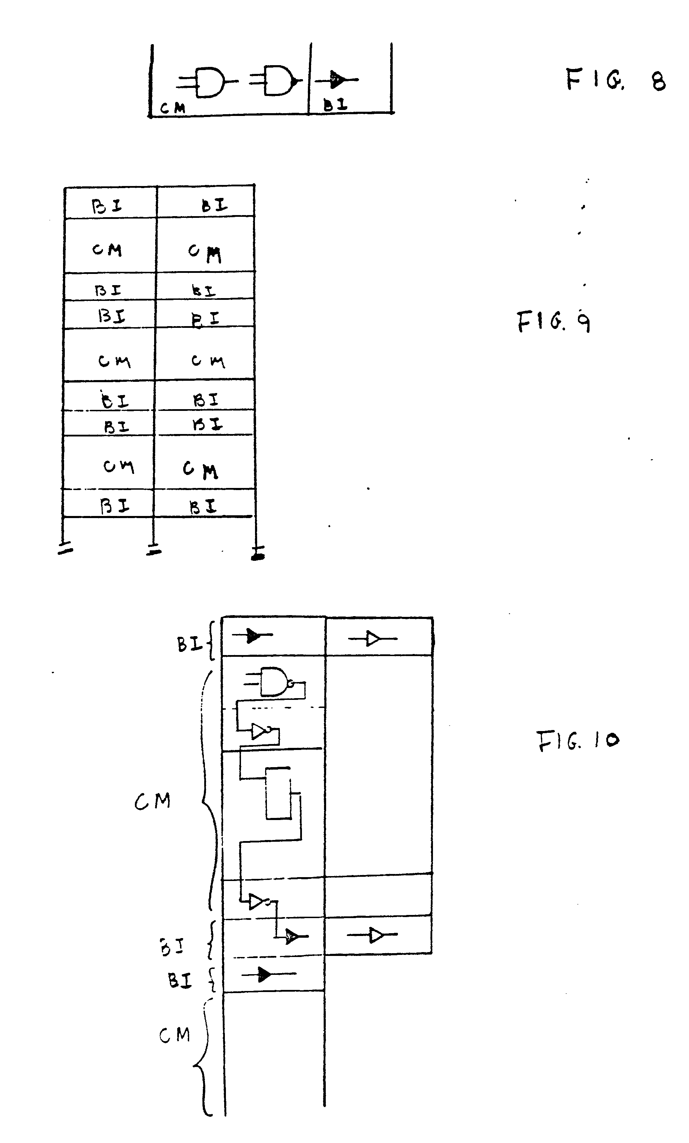

The present invention as described above utilizes a cell including several CMOS gates, typically 2 to 7, with one bipolar driver, as shown in Fig. 8. The CMOS gates may be connected in any combination, then connected to the driver. Each cell thus consists of a CMOS region designated CM in Fig. 8, and an associated bipolar region designated BI. Many such cells are included on the chip.

If a chip is required with many more bipolar drivers than usual, such as almost a one-to-one ratio of CMOS gates to bipolar drivers, the cells can be configured as shown in Fig. 9, with a repeated cell structure.

This second embodiment differs from the prior art in that the CMOS region in each cell is much larger, to allow for extra logic by connecting together several CMOS gates before using a bipolar driver, as shown in Fig. 10. This allows for higher density of logic gates than does the prior art. Fig. 10 shows in greater detail one vertical group of cells from Fig. 9.

The above described embodiments of the invention are made by semiconductor manufacturing methods that fabricate CMOS and bipolar devices . on the same VLSI chip. These fabrication methods are well-known in the art. The above embodiments can be produced using either standard cell design methods or by means of a "personality mask" whereby the electrical contacts and metallization layers are customized for a specific circuit design. In addition, the invention can be manufactured using a mask programming fabrication process. The invention could also, in a different embodiment, be fabricated so as to be field programmable.

In view of the above description, it will be obvious to one of ordinary skill in the art that various embodiments of the present invention may be provided without departing from the spirit and scope of the invention.

## Claims

1. An integrated circuit logic array comprising:
a first CMOS devices region;
a second bipolar and CMOS devices region; and
a third bipolar and CMOS input/output devices region.

2. The array of Claim 1, wherein the first region is at the core of the array and comprises the major part of the array.

3. The array of Claim 1, wherein the second region surrounds the first region.

4. The array of Claim 3, wherein the second region devices are BiCMOS devices.

5. The array of Claim 1, wherein the third region is at the periphery of the array.

6. The array of Claim 1, wherein the array is field programmable.

7. The array of Claim 1, wherein the array is mask programmed.

8. The array of Claim 1, wherein said input/output devices include selectable series resistors and parallel termination resistors.

9. An integrated circuit logic array comprising a plurality of cells, each cell comprising at least one CMOS gate and a bipolar driver.

10. The array of Claim 9, wherein each CMOS device in a cell is contiguous to other CMOS devices in that cell.

11. The array of Claim 9, wherein the array is field programmable.

12. The array of Claim 9, wherein the array is mask programmed.

FIG. 1(A)

loading

bipolar drivers (buffers)

FIG. 1(B)

I/O

FIG. 1C

Bipolar

buffer    pad

FIG. 1(D)

FIG. 1(E)

FIG. 2

FIG. 3

FIG. 4

FIG. 5

FIG. 6

FIG. 7

path1

path 2

FIG. 8

FIG. 9

FIG. 10